(19) **Europäisches Patentamt / European Patent Office / Office européen des brevets**

(11) **EP 4 606 926 A1**

(12) **EUROPEAN PATENT APPLICATION**
published in accordance with Art. 153(4) EPC

(43) Date of publication:
**27.08.2025 Bulletin 2025/35**

(21) Application number: **23897830.8**

(22) Date of filing: **29.11.2023**

(51) International Patent Classification (IPC):
**C23C 14/34** (2006.01)      **B01J 39/04** (2017.01)
**B01J 39/20** (2006.01)      **B01J 41/04** (2017.01)
**B01J 41/14** (2006.01)

(52) Cooperative Patent Classification (CPC):
**B01J 39/04; B01J 39/20; B01J 41/04; B01J 41/14; C23C 14/34**

(86) International application number:
**PCT/JP2023/042745**

(87) International publication number:
**WO 2024/117184 (06.06.2024 Gazette 2024/23)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **30.11.2022 JP 2022191776**

(71) Applicant: **Tosoh Corporation**
**Yamaguchi 746-8501 (JP)**

(72) Inventors:
• **KODA, Yoichiro**
  **Ayase-shi, Kanagawa 252-1123 (JP)**
• **MATSUNAGA, Osamu**
  **Ayase-shi, Kanagawa 252-1123 (JP)**
• **SHONO, Daiki**
  **Ayase-shi, Kanagawa 252-1123 (JP)**
• **MESUDA, Masami**
  **Ayase-shi, Kanagawa 252-1123 (JP)**

(74) Representative: **Müller-Boré & Partner**
**Patentanwälte PartG mbB**
**Friedenheimer Brücke 21**
**80639 München (DE)**

(54) **MOLYBDENUM SPUTTERING TARGET, METHOD FOR MANUFACTURING SAME, AND FILM FORMING METHOD FOR MOLYBDENUM FILM**

(57)    Disclosed is a molybdenum sputtering target having a content of metal impurities of 100 ppm by mass or less, a tungsten content of 50 ppm by mass or less, and an oxygen concentration of 50 ppm by mass or less.

*Fig.1*

## Description

### Technical Field

The present disclosure relates to a molybdenum sputtering target, a method for manufacturing the same, and a film forming method for a molybdenum film.

### Background Art

In recent years, EUV lithography using extreme ultraviolet (EUV) radiation has attracted attention as means for forming electronic circuit patterns of semiconductors. Mask blanks used in EUV lithography (EUV mask blanks) are produced by alternating stacking silicon thin films and molybdenum thin films on a glass substrate by a sputtering method, and the molybdenum thin films are formed using a molybdenum sputtering target.

As an existing molybdenum sputtering target, for example, a sputtering target having a molybdenum content of 99.99% by mass or more, a relative density of 98% or more, and an average crystal grain size of 400 $\mu$m or less has been reported (PTL 1), and it is disclosed that this enables the generation of particles during sputtering to be effectively reduced. It is also disclosed that a molybdenum sputtering target in which a total concentration of Cd, Cr, Fe, Mn, Ni, Ca, Co, Cu, Mg, Pb, Ti, Zn, Si, and Al in the sputtering target is 50 ppm or more and 1,000 ppm or less and which has a relative density of 99% or more can provide a thin film having less particles and good patterning performance (PTL 2).

### Citation List

### Patent Literature

PTL 1: International Publication No. 2019/176962
PTL 2: Japanese Unexamined Patent Publication No. 2005-154814

## Summary of Invention

### Technical Problem

To suppress the generation of particles during sputtering, molybdenum sputtering targets used for manufacturing EUV mask blanks are required to have higher purities, that is, higher molybdenum contents than existing molybdenum sputtering targets. However, in the molybdenum sputtering targets of PTLs 1 and 2, the reduction of metal impurities is insufficient from the viewpoints of an improvement in particles and an improvement in the yield in the manufacturing of EUV mask blanks. Furthermore, PTL 1 discloses that tungsten is an incidental impurity, that is, molybdenum contains tungsten, and that it is difficult to separate tungsten from molybdenum.

An object of the present disclosure is to provide at least one of a molybdenum sputtering target in which a metal impurity, in particular, tungsten, is further reduced compared with existing molybdenum sputtering targets, a method for manufacturing the same, and a film forming method for a molybdenum film using the same.

### Solution to Problem

The inventors of the present disclosure have conducted studies on the reduction of metal impurities, in particular, the reduction of tungsten in molybdenum sputtering targets. As a result, the inventors of the present disclosure have found a technique of separating tungsten, which has been difficult to separate from molybdenum to date, and found that this enables tungsten in a molybdenum sputtering target to be reduced.

Specifically, the scope of the present invention is defined by the claims, and the gist of the present disclosure is as follows.

(1) A molybdenum sputtering target having a content of metal impurities of 100 ppm by mass or less, a tungsten content of 50 ppm by mass or less, and an oxygen concentration of 50 ppm by mass or less.

(2) The molybdenum sputtering target according to (1) above, having a content of metal impurities of 70 ppm by mass or less, a tungsten content of 45 ppm by mass or less, and an oxygen concentration of 45 ppm by mass or less.

(3) The molybdenum sputtering target according to (1) or (2) above, having a content of metal impurities of 10 ppm by mass or more, a tungsten content of 5 ppm by mass or more, and an oxygen concentration of 5 ppm by mass or more.

(4) The molybdenum sputtering target according to any one of (1) to (3) above, in which a ratio $R_W$ of the tungsten content (ppm by mass) to the content of the metal impurities (ppm by mass) is 0.9 or less.

(5) The molybdenum sputtering target according to any one of (1) to (4) above, in which a ratio $R_W$ of the tungsten content (ppm by mass) to the content of the metal impurities (ppm by mass) is 0.1 or more.

(6) The molybdenum sputtering target according to any one of (1) to (5) above, in which the metal impurities are Li, Be, B, Na, Mg, Al, Si, K, Ca, Sc, Ti, V, Cr, Mn, Fe, Co, Ni, Cu, Zn, Ga, Ge, Rb, Sr, Y, Zr, Nb, Ru, Rh, Pd, Ag, Cd, In, Sn, Sb, Cs, Ba, La, Ce, Pr, Nd, Sm, Eu, Gd, Tb, Dy, Ho, Er, Tm, Yb, Lu, Hf, Ta, Re, Os, Ir, Pt, Au, Hg, Tl, Pb, Bi, Th, U, and W.

(7) A manufacturing method for manufacturing the molybdenum sputtering target according to any one of (1) to (6) above, the manufacturing method including a first ion-exchange step of bringing a first molybdenum solution into contact with a first ion-exchange resin which is one ion-exchange resin selected from a cation-exchange resin and an anion-exchange resin once or more to provide a second molybdenum solution; a second ion-exchange step of bringing the second molybdenum solution into contact with a second ion-exchange resin which is the other ion-exchange resin different from the first ion-exchange resin and selected from the cation-exchange resin and the anion-exchange resin once or more to provide a third molybdenum solution containing a solvent and a precipitate; an oxidation step of subjecting the precipitate after removal of the solvent from the third molybdenum solution to oxidation treatment to provide a molybdenum oxide powder; a reduction step of reducing the molybdenum oxide powder to provide a molybdenum powder; and a firing step of subjecting the molybdenum powder to pressure firing.

(8) The manufacturing method according to (7) above, in which the oxidation treatment is heat treatment performed in an air atmosphere at a temperature of 400°C or higher.

(9) The manufacturing method according to (7) or (8) above, in which the pressure firing is at least one of hot pressing and hot isostatic pressing (HIP).

(10) A film forming method for a molybdenum film, the film forming method including a step of manufacturing a molybdenum film by performing sputtering using the molybdenum sputtering target according to any one of (1) to (6) above.

**Advantageous Effects of Invention**

The present disclosure can provide at least one of a molybdenum sputtering target in which a metal impurity, in particular, tungsten, is further reduced compared with existing molybdenum sputtering targets, a method for manufacturing the same, and a film forming method for a molybdenum film using the same.

Preferably, use of the molybdenum sputtering target according to the present disclosure enables a reduction in the amount of particles generated during sputtering compared with the related art.

**Brief Description of Drawings**

[Fig. 1] Fig. 1 is a sectional view illustrating an embodiment of a molybdenum sputtering target according to the present disclosure.

[Fig. 2] Fig. 2 is a sectional view illustrating a substrate with a molybdenum film manufactured by a film forming method for a molybdenum film according to an embodiment of the present disclosure.

**Description of Embodiments**

Hereinafter, the present disclosure will be described in detail. However, the following description of constituent features is an example of embodiments of the present disclosure, and the present disclosure is not limited to these contents. The present disclosure includes any combination of the configurations and parameters disclosed in the present Description, and the present disclosure also includes ranges expressed by any combination of the upper and lower limits of values disclosed in the present Description.

<Molybdenum sputtering target>

The present embodiment relates to a molybdenum sputtering target (hereinafter, also referred to as a "Mo target"). In the present embodiment, the Mo target is a target composed mainly of molybdenum, further, a target composed substantially of molybdenum and, in particular, is a target composed mainly of molybdenum and used for sputtering, in particular, a target having a molybdenum content of 99.9% by mass or more.

The content of metal impurities in the Mo target of the present embodiment is 100 ppm by mass or less. If the content of the metal impurities exceeds 100 ppm by mass, the amount of particles during sputtering increases. The content of the metal impurities in the Mo target is preferably 80 ppm by mass or less, 70 ppm by mass or less, 65 ppm by mass or less, 50 ppm by mass or less, 45 ppm by mass or less, 30 ppm by mass or less, or 20 ppm by mass or less.

Preferably, the Mo target of the present embodiment contains no metal impurities (specifically, has a total content of metal impurities of 0 ppm by mass), but the Mo target may contain metal impurities. In this case, the total content of metal impurities of the Mo target of the present embodiment may be, for example, more than 0 ppm by mass, 0.01 ppm by mass or more, 0.1 ppm by mass or more, 1 ppm by mass or more, 5 ppm by mass or more, 10 ppm by mass or more, 15 ppm by mass or more, or 18 ppm by mass or more. The total content of metal impurities of the Mo target of the present embodiment is preferably more than 0 ppm by mass and 65 ppm by mass or less, more preferably 0.01 ppm by mass or more and 45 ppm by mass or less, still more preferably 0.1 ppm by mass or more and 20 ppm by mass or less.

The "metal impurities" in the present embodiment are metal elements other than molybdenum and are specifically Li, Be, B, Na, Mg, Al, Si, K, Ca, Sc, Ti, V, Cr, Mn, Fe, Co, Ni, Cu, Zn, Ga, Ge, Rb, Sr, Y, Zr, Nb, Ru, Rh, Pd, Ag, Cd, In, Sn, Sb, Cs, Ba, La, Ce, Pr, Nd, Sm, Eu, Gd, Tb, Dy, Ho, Er, Tm, Yb, Lu, Hf, Ta, Re, Os, Ir, Pt, Au, Hg, Tl, Pb, Bi, Th, U, and W.

The tungsten content in the Mo target of the present embodiment is 50 ppm by mass or less and is preferably 45 ppm by mass or less, 30 ppm by mass or less, 25 ppm by mass or less, 20 ppm by mass or less, 15 ppm by mass or less, or 10 ppm by mass or less. In general, tungsten is regarded as an incidental impurity of molybdenum, and it is very difficult to separate the two as well as to distinguish them from each other. Thus, in order to increase the purity of Mo targets, hitherto, a reduction in the amount of metal impurities other than tungsten has been mainly studied. In contrast, in the present embodiment, attention is focused on the fact that tungsten is the cause of the increase in particles, and that if the W concentration exceeds 50 ppm by mass, particles during sputtering are likely to be generated. Preferably, the Mo target of the present embodiment contains no tungsten (specifically, has a total content of tungsten of 0 ppm by mass), but the Mo target may contain tungsten. In this case, the total content of tungsten in the Mo target of the present embodiment may be, for example, more than 0 ppm by mass, 0.01 ppm by mass or more, 0.1 ppm by mass or more, 1 ppm by mass or more, 5 ppm by mass or more, or 10 ppm by mass or more. The total content of tungsten in the Mo target of the present embodiment is preferably more than 0 ppm by mass and 45 ppm by mass or less, more preferably 0.01 ppm by mass or more and 25 ppm by mass or less, still more preferably 0.1 ppm by mass or more and 10 ppm by mass or less.

A ratio $R_W$ of the tungsten content (ppm by mass) to the content of the metal impurities (ppm by mass) is not particularly limited as long as the ratio is 1 or less, but is preferably as small as possible from the viewpoint of suppressing the generation of particles during sputtering. The ratio $R_W$ is preferably, for example, 0.9 or less, 0.8 or less, 0.7 or less, 0.65 or less, or 0.6 or less.

The ratio $R_W$ may be, for example, 0.1 or more, 0.2 or more, 0.3 or more, 0.4 or more, or 0.5 or more. The ratio $R_W$ is preferably 0.1 or more and 0.7 or less, more preferably 0.2 or more and 0.65 or less, still more preferably 0.3 or more and 0.6 or less.

In the present embodiment, each of the content of the metal impurities and the tungsten content can be measured by glow discharge mass spectrometry (GDMS) using a typical glow discharge mass spectrometer (for example, ELEMENT GD PLUS, manufactured by Thermo Fisher Scientific Inc.). Conditions for GDMS measurement may be the following conditions.

(Measurement conditions)

Discharge gas: high-purity Ar (purity: 99.9999 vol%)
Discharge conditions: 12 mA, 0.8 kV
Analysis area: area with a diameter of 8 mm

The oxygen concentration in the Mo target of the present embodiment is 50 ppm by mass or less. If the oxygen concentration exceeds 50 ppm by mass, the amount of particles generated during sputtering increases. Since oxygen is the cause of the generation of particles, the oxygen concentration is preferably as low as possible and is preferably, for example, 45 ppm by mass or less, 40 ppm by mass or less, 35 ppm by mass or less, 30 ppm by mass or less, 25 ppm by mass or less, 20 ppm by mass or less, 15 ppm by mass or less, or 10 ppm by mass or less. The oxygen concentration may be, for example, 0.05 ppm by mass or more, 0.5 ppm by mass or more, 1 ppm by mass or more, 5 ppm by mass or more, or 10 ppm by mass or more. The oxygen concentration is preferably 0.05 ppm by mass or more and 45 ppm by mass or less, more preferably 0.5 ppm by mass or more and 30 ppm by mass or less, still more preferably 1 ppm by mass or more and 20 ppm by mass or less.

In the present embodiment, the "oxygen concentration" is determined on the basis of JIS Z 2613 using an oxygen-nitrogen analyzer (for example, model: ON736, manufactured by LECO Corporation) by measuring the masses of CO and $CO_2$ when a measurement sample is heated to 3,000°C, and determining a mass ratio [ppm by mass] of oxygen per mass of the measurement sample on the basis of the masses of CO and $CO_2$.

Measurement method: impulse furnace fusion-infrared absorption method
Mass of measurement sample: $0.1 \pm 0.05$ g

The relative density of the Mo target of the present embodiment is preferably 98% or more, 99% or more, 99.3% or more, 99.5% or more, or 99.8% or more. A high relative density makes it even easier to reduce the amount of particles generated during sputtering.

The "relative density" in the present embodiment is represented by the following formula.

$$\text{Relative density} = (\text{measured density/true density}) \times 100 \ (\%)$$

Here, the measured density is a value that can be measured by the Archimedes method in accordance with JIS R 1634, and the true density is the density ($10.22$ g/cm$^3$) of a target having a molybdenum content of 100% by mass.

The relative density is preferably high. The relative density may be 99.9% or less or 99.99% or less.

<Method for manufacturing Mo target>

The Mo target of the present embodiment can be manufactured by a manufacturing method including a first ion-exchange step of bringing a molybdenum solution (first molybdenum solution) into contact with one ion-exchange resin (first ion-exchange resin) selected from a cation-exchange resin and an anion-exchange resin once or more to provide a second molybdenum solution, a second ion-exchange step of bringing the molybdenum solution after the first ion-exchange step (the second molybdenum solution) into contact with the other ion-exchange resin (second ion-exchange resin) different from the first ion-exchange resin and selected from the cation-exchange resin and the anion-exchange resin once or more to provide a third molybdenum solution containing a solvent and a precipitate, an oxidation step of subjecting the precipitate remaining after removal of the solvent of the molybdenum solution after the second ion-exchange step (third molybdenum solution) to oxidation treatment to provide a molybdenum oxide powder, a reduction step of reducing the molybdenum oxide powder to provide a molybdenum powder, and a firing step of subjecting the molybdenum powder to pressure firing. Hereinafter, the first molybdenum solution, the second molybdenum solution, or the third molybdenum solution may be referred to as a "molybdenum solution".

The manufacturing method of the present embodiment includes a first ion-exchange step of bringing a first molybdenum solution into contact with one ion-exchange resin (first ion-exchange resin) selected from a cation-exchange resin and an anion-exchange resin once or more, and a second ion-exchange step of bringing the molybdenum solution after the first ion-exchange step (second molybdenum solution) into contact with the other ion-exchange resin (second ion-exchange resin) different from the first ion-exchange resin and selected from the cation-exchange resin and the anion-exchange resin once or more (hereinafter, both the first ion-exchange step and the second ion-exchange step are also referred to as an "ion-exchange step"). This enables the contents of metal impurities and tungsten in the Mo target to be reduced.

In each ion-exchange step, the number of times a molybdenum solution is brought into contact with the cation-exchange resin or the anion-exchange resin is one or more, and more preferably two or more. However, the number of times of contact may be five or less. There is no particular limitation as to which contact is performed first: contact between the molybdenum solution and the cation-exchange resin or the contact between the molybdenum solution and the anion-exchange resin. For example, after the first molybdenum solution is brought into contact with the cation-exchange resin in the first ion-exchange step, the second molybdenum solution may be brought into contact with the anion-exchange resin in the second ion-exchange step. Alternatively, after the first molybdenum solution is brought into contact with the anion-exchange resin in the first ion-exchange step, the second molybdenum solution may be brought into contact with the cation-exchange resin in the second ion-exchange step. Preferably, after the first molybdenum solution is brought into contact with the cation-exchange resin in the first ion-exchange step, the second molybdenum solution is brought into contact with the anion-exchange resin in the second ion-exchange step.

The contact between the molybdenum solution and the cation-exchange resin causes metal cations dissolved as cations in the molybdenum solution to be adsorbed and removed. The metal cations that adsorb on the cation-exchange resin can be, for example, one or more selected from the group consisting of chromium, iron, nickel, calcium, cobalt, copper, magnesium, and aluminum.

The cation-exchange resin used in the ion-exchange step may be any resin having a metal cation exchange capacity and may be, for example, a strongly acidic cation-exchange resin having a strongly acidic sulfone group as an exchanger. Specifically, the cation-exchange resin may be one or more selected from the group consisting of DIAION SK1B, DIAION SK110, Amberlite IR120B, and DOWEX 50WX8.

The contact between the molybdenum solution and the anion-exchange resin is performed for the purpose of removing tungsten dissolved as a metal anion in the molybdenum solution. To reduce the tungsten content, the number of times of contact between the molybdenum solution and the anion-exchange resin is preferably two or more. On the other hand, in the case where the tungsten concentration in the molybdenum solution has reached an equilibrium, the effect of reducing tungsten is not obtained even if the contact between the molybdenum solution and the anion-exchange resin is increased; therefore, the number of times of contact between the molybdenum solution and the anion-exchange resin may be four or less.

The anion-exchange resin used in the ion-exchange step may be any resin that exchanges metal anions and may be a styrene-based macroporous, weakly basic anionic-exchange resin. Specifically, the anion-exchange resin may be one or more selected from the group consisting of DIAION WA10, DIAION WA20, DIAION WA30, Amberlite IRA96SB, Amberlite IRA98, DOWEX 66, and DOWEX 77.

The contact between the molybdenum solution and the ion-exchange resin may be performed by any contact method. The method may be at least one of stirring/mixing and passing of the solution, and it is preferable to pass the molybdenum solution through the ion-exchange resin.

The space velocity SV during passing of the solution is not particularly limited and is, for example, 2 $h^{-1}$ or more and 20 $h^{-1}$ or less. When the space velocity SV is within the above range, the impurities can be reduced without impairing productivity. The space velocity SV is preferably 3 $h^{-1}$ or more or 4 $h^{-1}$ or more, and is preferably 15 $h^{-1}$ or less or 10 $h^{-1}$ or less.

The molybdenum solution used in the ion-exchange step may be an acid solution in which at least one of metallic molybdenum and a molybdenum compound is dissolved, and is preferably an acid solution in which metallic molybdenum is dissolved. The acid contained in the acid solution may be, for example, one or more selected from the group consisting of hydrogen peroxide acid, hydrochloric acid, and sulfuric acid and is preferably at least one of hydrogen peroxide acid and hydrochloric acid. The molybdenum concentration in the molybdenum solution is preferably 50 g/L or more and 300 g/L or less. When the molybdenum concentration is within the above range, it is possible to suppress a reduction in productivity and precipitation of molybdic acid when the molybdenum solution is passed through the ion-exchange resin. The molybdenum concentration is more preferably 100 g/L or more and 200 g/L or less.

In the oxidation step, the precipitate remaining after removal of the solvent of the third molybdenum solution after the second ion-exchange step is subjected to oxidation treatment to provide a molybdenum oxide powder.

Any method for removing the solvent in the third molybdenum solution may be employed, and the molybdenum solution obtained in the second ion-exchange step (third molybdenum solution) may be dried. The drying method is not particularly limited as long as the solvent can be removed. The method may be, for example, drying the third molybdenum solution in an air atmosphere at a temperature of 60°C or higher and 100°C or lower for 48 hours of more and 96 hours or less (evaporation-to-dryness method).

The oxidation treatment may be any method as long as the precipitate remaining after removal of the solvent of the third molybdenum solution can be oxidized, and the precipitate may be heated (for example, fired) in an air atmosphere at a temperature of 400°C or higher. The upper limit of the firing temperature (heating temperature) may be, for example, 600°C.

In the reduction step, the molybdenum oxide powder is reduced to provide a molybdenum powder. The reducing atmosphere is not particularly limited, may be one or more selected from the group consisting of a hydrogen-containing atmosphere, a carbon monoxide-containing atmosphere, and an ammonia-containing atmosphere, and is preferably a hydrogen-containing atmosphere. In the reduction in a hydrogen-containing atmosphere, molybdenum oxide is fired in a furnace in a hydrogen atmosphere. The treatment temperature is not particularly limited and is preferably 900°C or higher and 1,200°C or lower. When the treatment temperature is within the above temperature range, the reduction reaction from molybdenum oxide to molybdenum proceeds, and a molybdenum powder having a low oxygen content is easily obtained. The treatment temperature is more preferably 950°C or higher and 1,150°C or lower.

In the firing step, the molybdenum powder is pressure-fired. It is only necessary that the firing method be pressure sintering (also referred to as "pressure firing"). The pressure sintering may be at least one of hot pressing and hot isostatic pressing (HIP).

In the firing step, as the molybdenum powder, a non-molded body (non-compact) of the powder may be provided, or a molded body (compact) of the powder may be provided instead of the non-molded body. The method for molding the molybdenum powder is not particularly limited and may be, for example, at least one of press molding and cold isostatic pressing (CIP) treatment. A primary molded body obtained by press molding is subjected to CIP treatment to thereby obtain a molded body (CIP molded body). The pressure that is a condition for the press molding may be, for example, 5 MPa or more and 50 MPa or less, and the pressure that is a condition for the CIP treatment may be, for example, 100 MPa or more and 500 MPa or less.

The shape of the molded body of the molybdenum powder (molybdenum molded body) may be any shape as long as the molded body can be subjected to pressure sintering, and may be, for example, one or more selected from the group consisting of a disk shape, a columnar shape, and a polyhedral shape.

The pressure sintering is preferably hot pressing and hot isostatic pressing (HIP) because the density of the sintered body is likely to be increased, and the oxygen concentration in the sintered body is likely to be reduced.

The hot-pressing temperature is preferably 1,300°C or higher and 1,500°C or lower. When the hot-pressing temperature is within the above temperature range, the oxygen content in the sintered body can be sufficiently reduced. The hot-pressing temperature is more preferably 1,350°C or higher and 1,450°C or lower. The hot-pressing pressure is preferably 1 MPa or more and 100 MPa or less, more preferably 10 MPa or more and 70 MPa or less. The temperature increase rate to the hot-pressing temperature is not limited and may be, for example, 100 °C/hour or more and 800 °C/hour or less, preferably 300 °C/hour or more and 700 °C/hour or less.

It is only necessary that the atmosphere of hot pressing be a vacuum atmosphere.

The holding time at the hot-pressing temperature is not particularly limited, may be set for any period of time depending on, for example, the amount of molybdenum used in the firing step, the firing method, and characteristics of a firing furnace used, and can be appropriately determined such that the oxygen concentration of the sintered body after hot pressing is reduced. The holding time at the hot-pressing temperature is, for example, 1 hour or more and 15 hours or less.

To realize an increase in the density and a decrease in the oxygen content of the sintered body after hot pressing, after the hot-pressing treatment, the sintered body may be subjected to vacuum firing prior to the HIP treatment. The conditions for the vacuum firing are not particularly limited, and the firing can be performed, for example, in a vacuum atmosphere at 1,600°C or higher and 1,800°C or lower.

After the hot-pressing treatment, hot isostatic pressing (HIP) treatment is preferably performed in order to obtain a sintered body having a high density. The temperature of the HIP treatment is preferably 1,600°C or higher and 1,900°C or lower. When the temperature is within the above range, the density of the sintered body can be improved. The temperature increase rate to the HIP treatment is not limited and may be, for example, 100 °C/hour or more and 800 °C/hour or less, preferably 300 °C/hour or more and 700 °C/hour or less. The atmosphere of the HIP treatment may be any non-oxidizing atmosphere, and is preferably an inert atmosphere or a reducing atmosphere, more preferably an argon atmosphere. The pressure of the HIP treatment is preferably 50 MPa or more and 200 MPa or less. When the pressure of the HIP treatment is within the above pressure range, the density of the sintered body can be improved. The treatment time is not particularly limited and can be appropriately determined depending on characteristics of a HIP treatment furnace used such that the relative density becomes a sufficient value. The firing time is, for example, 1 hour or more and 15 hours or less.

The sintered body obtained by the pressure firing described above may be provided as a Mo target as it is, or may be processed into a desired size to provide a Mo target. The Mo target composed of the above-described HIP sintered body or a processed body thereof may be bonded to a backing plate to provide a Mo target product composed of a joined body of the Mo target and the backing plate.

<Film forming method for molybdenum film>

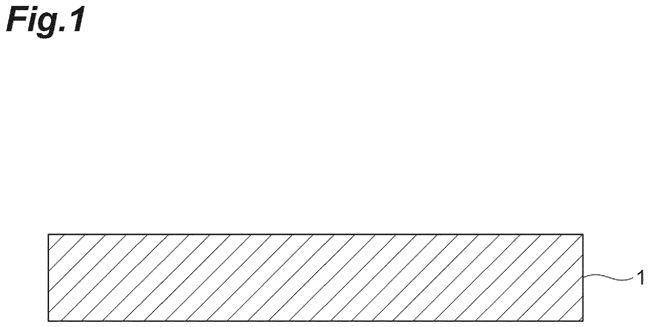

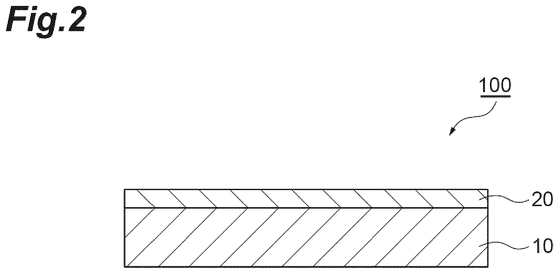

A film forming method for a molybdenum film of the present embodiment includes a step of manufacturing a molybdenum film by performing sputtering using the Mo target of the present embodiment. Specifically, by performing sputtering using a Mo target 1 illustrated in Fig. 1, a molybdenum film 20 illustrated in Fig. 2 can be manufactured.

As illustrated in Fig. 2, a substrate with a molybdenum film 100 includes a substrate 10 and a molybdenum film 20 formed on the substrate 10. Sputtering using the Mo target 1 can provide the molybdenum film 20 in which the generation of particles is suppressed during the formation of the film.

Examples of the substrate 10 include, but are not particularly limited to, a glass substrate and a quartz substrate.

The temperature of the substrate 10 (film formation temperature) is not particularly limited and may be, for example, room temperature (25°C).

The process gas used during film formation is not particularly limited as long as the gas species causes sputtering upon discharge and may be, for example, argon.

The discharge power during film formation is not particularly limited and may be, for example, 2.5 W/cm$^2$ or more and 50 W/cm$^2$ or less.

The film formation time is not particularly limited and may be, for example, 10 minutes or more and 60 minutes or less.

Sputtering can be performed using a typical sputtering apparatus. Conditions for sputtering are not particularly limited, and sputtering can be performed, for example, under the following conditions.

Discharge method: ion beam sputtering
Target size: 4 inches
Target inclination angle: 45°
Introduced gas: argon
Microwave power supply: 100 W
Substrate: 4-inch silicon wafer

Substrate plane orientation: (001) plane
Accelerating voltage: 2 kW
Film formation temperature: 25°C
Film formation time: 10 min
Degree of vacuum: $7 \times 10^{-4}$ Pa

The number of particles in the molybdenum film 20 of the present embodiment can be evaluated using, for example, an atomic force microscope (SPM-9600: manufactured by Shimadzu Corporation).

The number of particles can be specifically evaluated as described below.

Of a disk-shaped silicon wafer with a molybdenum film having a radius R, portions with a size of 15 mm × 15 mm are cut out from a total of five points, namely, one point at the center of the wafer, two points located at positions of 0.5R from the center of the wafer, and two points at outer peripheral portions (portions located at positions of R from the center of the wafer), subjected to ultrasonic cleaning for 120 seconds with electronic grade acetone, and then dried with compressed nitrogen to provide measurement samples. Subsequently, of the surfaces of the molybdenum films of the measurement samples, a total of 25 fields of view, that is, 5 fields of view of a region of 2 $\mu$m × 2 $\mu$m per measurement sample are observed, and the calculation can be performed by converting the number of detected particles into the number in a region per 1 cm × 1 cm.

For the analysis, the open source software Gwyddion may be used. On the basis of the maximum height (TOP) and minimum height (BTM) of an AFM image, which is an image observed with the atomic force microscope (AFM), a threshold of the height is set at a position of height 30% from the minimum height when the value of TOP - BTM is assumed to be a reference (100%). Furthermore, island-like portions having a circular equivalent diameter of 15 nm or more and located at a height equal to or higher than the threshold of the height are defined as particles.

**Examples**

Hereinafter, the present disclosure will be described by way of Examples; however, the present disclosure is not limited to Examples below.

(Example 1)

A polyethylene container was charged with 150 g of a commercially available molybdenum powder (purity: 99.95%, particle size: 3 to 7 $\mu$m, product name: PD-8002, manufactured by H.C. Starck GmbH) and 750 g of pure water to obtain slurry. After the polyethylene container was placed in a thermostatic chamber at 25°C, the slurry was stirred while cooling, and 544 g of hydrogen peroxide (special grade reagent, purity: 99.99%, manufactured by FUJIFILM Wako Pure Chemical Corporation) was gradually added to the slurry such that an increase in the temperature due to heat of reaction did not exceed 65°C. After the addition of hydrogen peroxide, the resulting solution was cooled to room temperature, a dissolution residue was then removed by filtration to obtain an acid solution. The amount of molybdenum in the acid solution was calculated from the amount of molybdenum in the dissolution residue, and pure water was then added to the acid solution such that the molybdenum concentration became 120 g/L to obtain a molybdenum solution.

The molybdenum solution was passed through a cation-exchange resin (product name: Amberlite IR120B, manufactured by ORGANO CORPORATION) once and then passed through an anion-exchange resin (product name: Amberlite IRA96SB, manufactured by ORGANO CORPORATION) once. Each of the solution passing velocities through the cation-exchange resin and the anion-exchange resin was set as SV = 6 $h^{-1}$. The molybdenum solution after passing through the ion-exchange resins was dried in an air atmosphere at 80°C for 72 hours to remove the solvent, and the remaining precipitate was then fired in an air atmosphere at 500°C for two hours to obtain a molybdenum oxide powder. Hydrogen reduction was performed by firing the molybdenum oxide powder under the following firing conditions to obtain 125 g of a molybdenum powder.

(Firing conditions)

Temperature increase rate: 600 °C/hour
Firing atmosphere: hydrogen
Firing temperature: 1,100°C
Firing time: 5 hours

The process from the dissolution of a molybdenum powder to the firing was performed a total of six times to obtain 750 g of a molybdenum powder. The obtained molybdenum powder was placed in a die with a diameter of 150 mm and a height of 50 mm, press-molded at a pressure of 20 MPa, and then CIP-molded at a pressure of 300 MPa to obtain a disk-shaped CIP molded body with a diameter of 122 mm and a thickness of 9 mm. The CIP molded body was subjected to hot-pressing treatment under the following conditions to obtain a hot-press sintered body.

(Treatment conditions)

Temperature increase rate: 600 °C/hour
Atmosphere: vacuum
Holding temperature: 1,350°C
Pressure: 50 MPa
Holding time: 10 hours

Subsequently, the hot-press sintered body was subjected to HIP treatment under the following conditions. A HIP sintered body obtained by the HIP treatment had a relative density of 99.0%.

(Treatment conditions)

Temperature increase rate: 600 °C/hour
Atmosphere: argon
Holding temperature: 1,800°C
Pressure: 100 MPa
Holding time: 10 hours

The obtained HIP sintered body was cut and ground to a size of 101.6 mm in diameter and 6 mm in thickness to provide a Mo target of this Example.

(Example 2)

A Mo target of this Example was produced by the same method as in Example 1 except that the number of times the solution was passed through the anion-exchange resin was two, and the pressure during hot pressing was 80 MPa.

(Example 3)

A Mo target was produced by the same method as in Example 1 except that each of the solution passing velocities through the cation-exchange resin and the anion-exchange resin was set as $SV = 4\ h^{-1}$, the solution was passed through the cation-exchange resin three times and then passed through the anion-exchange resin three times, the firing temperature and the firing time which were hydrogen reduction treatment conditions were 1,200°C and five hours, respectively, the holding temperature, the holding time, and the pressure which were hot-pressing treatment conditions were 1,400°C, five hours, and 100 MPa, respectively, and the holding temperature, the holding time, and the pressure which were HIP treatment conditions were 1,850°C, five hours, and 200 MPa, respectively.

(Comparative Example 1)

A Mo target was produced by the same method as in Example 1 except that the solution was passed through neither the cation-exchange resin nor the anion-exchange resin.

(Comparative Example 2)

A Mo target was produced by the same method as in Example 1 except that the solution was not passed through the anion-exchange resin.
Table 1 shows the conditions for producing the Mo targets, and Table 2 shows the relative densities and impurity analysis results (impurity contents) of the Mo target.

[Table 1]

Conditions for producing Mo target

| | Passing of solution through ion-exchange resin | | | | Hydrogen reduction | | Hot pressing | | | HIP | | |
|---|---|---|---|---|---|---|---|---|---|---|---|---|
| | Cation-exchange resin | | Anion-exchange resin | | Firing temperature (°C) | Firing time (hr) | Holding temperature (°C) | Pressure (MPa) | Holding time (hr) | Holding temperature (°C) | Pressure (MPa) | Holding time (hr) |
| | SV (h⁻¹) | Number of times of passing of solution (times) | SV (h⁻¹) | Number of times of passing of solution (times) | | | | | | | | |
| Example 1 | 6 | 1 | 6 | 1 | 1100 | 5 | 1350 | 50 | 10 | 1800 | 100 | 10 |
| Example 2 | 6 | 1 | 6 | 2 | 1100 | 5 | 1350 | 80 | 10 | 1800 | 100 | 10 |
| Example 3 | 4 | 3 | 4 | 3 | 1200 | 5 | 1450 | 100 | 5 | 1850 | 200 | 5 |
| Comparative Example 1 | - | - | - | - | 1100 | 5 | 1350 | 50 | 10 | 1800 | 100 | 10 |
| Comparative Example 2 | 6 | 1 | - | - | 1100 | 5 | 1350 | 50 | 10 | 1800 | 100 | 10 |

[Table 2]

| | Relative density | Impurity analysis results (Impurity contents) | | | |
|---|---|---|---|---|---|
| | | W | Metals other than W | Metal impurities | Oxygen |
| | % | ppm by mass | ppm by mass | ppm by mass | ppm by mass |
| Example 1 | 99.0 | 45 | 20 | 65 | 45 |
| Example 2 | 99.5 | 25 | 16 | 41 | 28 |
| Example 3 | 99.8 | 10 | 8 | 18 | 10 |
| Comparative Example 1 | 99.0 | 99 | 80 | 179 | 90 |
| Comparative Example 2 | 99.0 | 99 | 38 | 137 | 62 |

(Film formation of Mo film)

The Mo targets obtained in Example 1 and Comparative Example 1 were each machined and then joined to a backing plate made of oxygen-free copper to produce Mo target products composed of a joined body of the Mo target and the backing plate. Subsequently, sputtering was performed using the Mo target of the Mo target product under the following conditions to form a Mo film on a substrate.

(Sputtering conditions)

Discharge method: ion beam sputtering

Target size: 4 inches

Target inclination angle: 45°

Introduced gas: argon

Microwave power supply: 100 W

Substrate: 4-inch silicon wafer

Substrate plane orientation: (001) plane

Accelerating voltage: 2 kV

Film formation temperature: 25°C

Film formation time: 10 min

Degree of vacuum: $7 \times 10^{-4}$ Pa

(Calculation of the number of particles)

For each of the Mo films obtained as described above, the number of particles was calculated. The number of particles was determined using an atomic force microscope (SPM-9600: manufactured by Shimadzu Corporation). Specifically, of the silicon wafer with the molybdenum film, portions with a size of 15 mm × 15 mm were cut out from a total of five points, namely, one point at the center of the wafer, two points located at positions of 0.5R from the center of the wafer, and two points at outer peripheral portions (portions located at positions of R from the center of the wafer). These portions were subjected to ultrasonic cleaning for 120 seconds with electronic grade acetone and then dried with compressed nitrogen to provide measurement samples. Subsequently, of the surfaces of the molybdenum films of the measurement samples, a total of 25 fields of view, that is, 5 fields of view of a region of 2 μm × 2 μm per measurement sample were observed, and the calculation was performed by converting the number of detected particles into the number in a region per 1 cm × 1 cm. For the analysis, the open source software Gwyddion was used. On the basis of the maximum height (TOP) and minimum height (BTM) of an AFM image, which was an image observed with the atomic force microscope (AFM), a threshold of the height was set at a position of height 30% from the minimum height when the value of TOP - BTM was assumed to be a reference (100%). Furthermore, island-like portions having a circular equivalent diameter of 15 nm or more and located at a height equal to or higher than the threshold of the height were defined as particles. Table 3 shows the calculation results of the number of particles when the film formation was performed using the Mo targets.

[Table 3]

|  | Number of particles |
| --- | --- |
|  | particles/(1 cm × 1 cm) |
| Example 1 | 0 |
| Comparative Example 1 | 2000000 |

The present application is based on Japanese Patent Application (No. 2022-191776) filed on November 30, 2022, the entire contents of which are incorporated herein by reference. Furthermore, all the references cited herein are incorporated as a whole.

**Reference Signs List**

1 Mo target (molybdenum sputtering target), 20 molybdenum film

**Claims**

1.  A molybdenum sputtering target having a content of metal impurities of 100 ppm by mass or less, a tungsten content of 50 ppm by mass or less, and an oxygen concentration of 50 ppm by mass or less.

2.  The molybdenum sputtering target according to claim 1, having a content of metal impurities of 70 ppm by mass or less, a tungsten content of 45 ppm by mass or less, and an oxygen concentration of 45 ppm by mass or less.

3.  The molybdenum sputtering target according to claim 1 or 2, having a content of metal impurities of 10 ppm by mass or more, a tungsten content of 5 ppm by mass or more, and an oxygen concentration of 5 ppm by mass or more.

4.  The molybdenum sputtering target according to any one of claims 1 to 3, wherein a ratio $R_W$ of the tungsten content (ppm by mass) to the content of the metal impurities (ppm by mass) is 0.9 or less.

5.  The molybdenum sputtering target according to any one of claims 1 to 4, wherein a ratio $R_W$ of the tungsten content (ppm by mass) to the content of the metal impurities (ppm by mass) is 0.1 or more.

6.  The molybdenum sputtering target according to any one of claims 1 to 5, wherein the metal impurities are Li, Be, B, Na, Mg, Al, Si, K, Ca, Sc, Ti, V, Cr, Mn, Fe, Co, Ni, Cu, Zn, Ga, Ge, Rb, Sr, Y, Zr, Nb, Ru, Rh, Pd, Ag, Cd, In, Sn, Sb, Cs, Ba, La, Ce, Pr, Nd, Sm, Eu, Gd, Tb, Dy, Ho, Er, Tm, Yb, Lu, Hf, Ta, Re, Os, Ir, Pt, Au, Hg, Tl, Pb, Bi, Th, U, and W.

7.  A manufacturing method for manufacturing the molybdenum sputtering target according to any one of claims 1 to 6, the manufacturing method comprising:

    a first ion-exchange step of bringing a first molybdenum solution into contact with a first ion-exchange resin which is one ion-exchange resin selected from a cation-exchange resin and an anion-exchange resin once or more to provide a second molybdenum solution;
    a second ion-exchange step of bringing the second molybdenum solution into contact with a second ion-exchange resin which is the other ion-exchange resin different from the first ion-exchange resin and selected from the cation-exchange resin and the anion-exchange resin once or more to provide a third molybdenum solution containing a solvent and a precipitate;
    an oxidation step of subjecting the precipitate remaining after removal of the solvent from the third molybdenum solution to oxidation treatment to provide a molybdenum oxide powder;
    a reduction step of reducing the molybdenum oxide powder to provide a molybdenum powder; and

a firing step of subjecting the molybdenum powder to pressure firing.

8. The manufacturing method according to claim 7, wherein the oxidation treatment is heat treatment performed in an air atmosphere at a temperature of 400°C or higher.

9. The manufacturing method according to claim 7 or 8, wherein the pressure firing is at least one of hot pressing and hot isostatic pressing (HIP).

10. A film forming method for a molybdenum film, the film forming method comprising a step of manufacturing a molybdenum film by performing sputtering using the molybdenum sputtering target according to any one of claims 1 to 6.

Fig.1

1

## Fig.2

# INTERNATIONAL SEARCH REPORT

| International application No. |
| --- |
| **PCT/JP2023/042745** |

**A.    CLASSIFICATION OF SUBJECT MATTER**

*C23C 14/34*(2006.01)i; *B01J 39/04*(2017.01)i; *B01J 39/20*(2006.01)i; *B01J 41/04*(2017.01)i; *B01J 41/14*(2006.01)i
FI:   C23C14/34 A; B01J39/04; B01J41/04; B01J39/20; B01J41/14

According to International Patent Classification (IPC) or to both national classification and IPC

**B.    FIELDS SEARCHED**

Minimum documentation searched (classification system followed by classification symbols)

C23C14/34; B01J39/04; B01J39/20; B01J41/04; B01J41/14; C22B34/34; C22B34/36; B22F1/00

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

JSTPlus/JMEDPlus/JST7580 (JDreamIII)

**C.    DOCUMENTS CONSIDERED TO BE RELEVANT**

| Category* | Citation of document, with indication, where appropriate, of the relevant passages | Relevant to claim No. |
| --- | --- | --- |
| X | WO 2011/004887 A1 (KABUSHIKI KAISHA TOSHIBA) 13 January 2011 (2011-01-13) claims, paragraphs [0070]-[0083] | 1-10 |
| A | JP 2005-154814 A (TOSOH CORP.) 16 June 2005 (2005-06-16) entire text | 1-10 |
| A | CN 114574821 A (BEIJING SCIENCE AND TECHNOLOGY UNIVERSITY) 03 June 2022 (2022-06-03) entire text | 1-10 |

☐ Further documents are listed in the continuation of Box C.     ☑ See patent family annex.

| | | |
| --- | --- | --- |
| * | Special categories of cited documents: | "T" later document published after the international filing date or priority date and not in conflict with the application but cited to understand the principle or theory underlying the invention |
| "A" | document defining the general state of the art which is not considered to be of particular relevance | |
| "D" | document cited by the applicant in the international application | "X" document of particular relevance; the claimed invention cannot be considered novel or cannot be considered to involve an inventive step when the document is taken alone |
| "E" | earlier application or patent but published on or after the international filing date | |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&" document member of the same patent family |

| Date of the actual completion of the international search | Date of mailing of the international search report |
| --- | --- |
| **21 February 2024** | **05 March 2024** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

INTERNATIONAL SEARCH REPORT
Information on patent family members

International application No.

**PCT/JP2023/042745**

| Patent document cited in search report | | | Publication date (day/month/year) | Patent family member(s) | | | Publication date (day/month/year) |
|---|---|---|---|---|---|---|---|
| WO | 2011/004887 | A1 | 13 January 2011 | CN | 102470437 | A | |
| JP | 2005-154814 | A | 16 June 2005 | (Family: none) | | | |
| CN | 114574821 | A | 03 June 2022 | (Family: none) | | | |

Form PCT/ISA/210 (patent family annex) (July 2022)

**EP 4 606 926 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2019176962 A
- JP 2005154814 A
- JP 2022191776 A